# EUROPEAN PATENT APPLICATION

(11) **EP 1 130 647 A2**
(43) Date of publication of application: **05.09.2001**
(21) Application number: 01600004.4
(22) Date of filing: 28.02.2001
(51) Int. Cl.: H01L 25/16

(54) **Procedure for the wafer scale integration of gallium arsenide based optoelectronic devices with silicon based integrated circuits**

(30) Priority: 29.02.2000 GR 2000100066
(71) Applicant: Halkias, George, 15232 Halandri, Attiki (GR); Tsoukalas, Dimitrios, 16675 Glyfada, Attika (GR); Georgakilas, Alexandros, 71202 Heraklion - Crete (GR); Foundation for Research and Technology-Hellas (FO.R.T.H.), Institute of Electronic Structure and Laser, 711 10 Heraklion (Crete) (GR); National Center for Scientific Research "Demokritos"/Institute of Microelectronics (NCSR "Demokritos"/Inst. of Microelec.), 15310 Agia Paraskevi, Attiki (GR)
(72) Inventor: Georgakilas, Alexandros, 71110 Heraklion, Crete (GR); Halkias, George, 15310 Agia Paraskevi, Attiki (GR); Tsoukalas, Dimitris, 15310 Agia Paraskevi, Attiki (GR)

(57) **Abstract**

An integrated fabrication procedure of optoelectronic (OE) system, comprising light-emitting diodes (Lasers or LEDs) as well as photodetectors fabricated with III-V compound semiconductor epitaxial layers deposited on a crystalline wafer bonded on a Silicon wafer on which the CMOS/BiCMOS integrated circuits have been fabricated, characterized in that the bonding of the wafer containing the III-V epitaxial layers with the Silicon wafer is achieved either with an adhesive epoxy or with a Wafer Bonding procedure through the employment of an intermediate layer of SOG, SiO₂ or Si₃N₄ (or a combination of them); the intermediate layers are deposited at low temperature (below 450°C) and the bonding is accomplished at even lower temperature (below 250°C). The invention is characterized in that the integration of the microelectronic with the optoelectronic components is achieved in a three-dimensional arrangement using a wafer scale fabrication procedure.

## Description

This invention concerns the exploitation of the mature Silicon (Si) technology of digital and/or analogue Integrated Circuits (IC) in combination with Optoelectronic (OE) devices based on III-V compound semiconductors (laser diodes, Light Emitting Diodes (LED), optical modulators and photodetectors fabricated on Gallium Arsenide (GaAs) or other substrates adequate for such OE devices). The combination of OE devices with Silicon ICs is desirable for the common exploitation of the tremendous integration potential of the CMOS/BiCMOS ICs and of the very high speed achieved when the signal transmission is accomplished using photonics. In the past, the combination of Silicon technology with Gallium Arsenide OE devices was achieved using different functional modules for applications mainly concerning long distance telecommunications. Recently, new applications of short haul OE interconnections (module-to-module in computer systems, inter-chip and even intra-chip) attracted the interest of the researchers in microelectronics. The mass introduction of these new applications requires a drastic improvement of the following domains of the combined microelectronic and optoelectronic technologies: 1) Miniaturization of the system 2) Manufacturability 3) Mass production efficiency 4) Cost reduction.
These domains will be drastically improved by the present invention.

The first efforts to deal with the above four technological requirements in OE systems concerned the transition from the discrete electronic components technology to the hybrid technology [Graig Armiento et al., "Gigabit Transmitter Array Modules on Silicon Waferboard, IEEE Trans. on Components, Hybrids and Manufacturing Technology, Vol. 15, No 6, Dec. 1992, pp.1072-1079]. In hybrid technology the Silicon chips as well as the OE devices are bonded onto the substrate (from Al₂O₃, Si, etc.) using eutectic alloys or adhesive epoxies. The optical interconnection is accomplished using optical fibers or free space transmission whenever geometry is not a limiting factor. The last advances in hybrid technology of Silicon IC combination with OE semiconductor devices led to the adoption of flip-chip technology for the mounting of the OE chips directly onto the Silicon motherboard; The alignment of the optical fiber with the OE devices is insured by proper arrangements such as V-grooves on the Silicon substrates. ["Low-Cost Packaging of Semiconductor Laser Arrays using Passive Self-Aligned Flip-Chip Technique on Si Motherboard", W. Hunziker, W. Vogt, H. Melchior, R. Germann and C. Harder, Proc. 46th Electronic Components and Technology Conf. ECTC'96, Orlando FL, May 1996, pp. 8-12].
A different approach of the Silicon IC combination with OE devices is the fabrication of the OE devices in layers of Gallium Arsenide (or related III-V semiconductors) which are epitaxially deposited on the Silicon semiconductor layers. This approach is still in a very initial phase and it is questionable whether it can ever reach an industrial level of prototyping due to a variety of problems associated to the poor crystalline quality of the epitaxial Gallium Arsenide and to existing incompatibilities between the Silicon and the Gallium Arsenide technology. ["Effects of (100) Si Tilting Angle and Prelayer Conditions on GaAs/Si Heterostructures", A. Georgakilas, Ch. Papavassiliou, G. Constantinidis, K. Tsagaraki, H. Krasny, E. Lochtermann and P. Panayotatos, Appl. Surf. Sci 102, 1996, pp. 67-72].
In contrast to the past approaches, the present invention allow to fabricate the OE devices on the entire Gallium Arsenide wafer in a three dimensional arrangement relative to the surface of the Silicon wafer. The fabrication procedure involves the bonding of the Gallium Arsenide and the Silicon wafers when all the fabrication process of the ICs are finished on the Silicon substrate.

While in hybrid technology the bonding of chips is achieved using eutectic alloys or adhesive epoxies, with conventional or flip-chip arrangement, in the present invention the entire Gallium Arsenide wafer is bonded onto the Silicon wafer on which the IC fabrication procedure is already finished. Then, the bonded Gallium Arsenide wafer is thinned down so as only the active layers of the OE devices are remaining intact. Afterwards, the fabrication procedure of the OE devices is performed followed by their electrical interconnection with Silicon ICs and the processing of the optical waveguides whenever needed for the guidance of the optical signal in paths parallel to the Silicon surface for the optical link of the different parts of the circuitry. All these fabrication steps must be performed at temperatures lower than 450° C to avoid the degradation of the Silicon ICs. However, during the wafer bonding step temperature must be kept below 250° C to avoid debonding of the two wafers due to the difference in their Thermal Expansion Coefficient.

Bonding of the two wafers at temperatures lower than 250° C is achieved either with utilization of adhesive epoxies or with a low temperature wafer bonding process employing intermediate layers of SiO₂, Si₃N₄ and/or Spin-On-Glass (SOG). A critical point is the mirror-like polishing of the intermediate layers (SiO₂, Si₃N₄ or SOG) using a procedure of Chemical-Mechanical Polishing (CMP) for uniform and void free bonding of the two wafers. An additional critical point in the fabrication procedure is the uniform and smooth thinning of the Gallium Arsenide wafer using Chemical-Mechanical Thinning and Polishing to achieve a top surface with the adequate quality for the fabrication of OE devices.

The main characteristic of the present invention is that the fabrication procedure of the entire OE system is performed in a wafer scale for the Silicon as well as for the Gallium Arsenide; In contrast hybrid technology utilizes bonding of discrete chips of OE semiconductor devices. Consequently, the entire fabrication procedure is realized according to VLSI-like fabrication methodology. This results to significant enhancement of the fabrication procedure in mass production environment so as to expect a drastic reduction in fabrication costs per unit of OE system. An important consequence of the expected mass production of compact low-cost OE systems will be the large introduction of optical links within the computing workstations and the personal computers (PC). It is expected that this introduction of optical interconnections will be beneficial to the intra-chip optical links. In addition, the technology of the present invention will open the path for intra-chip optical links.

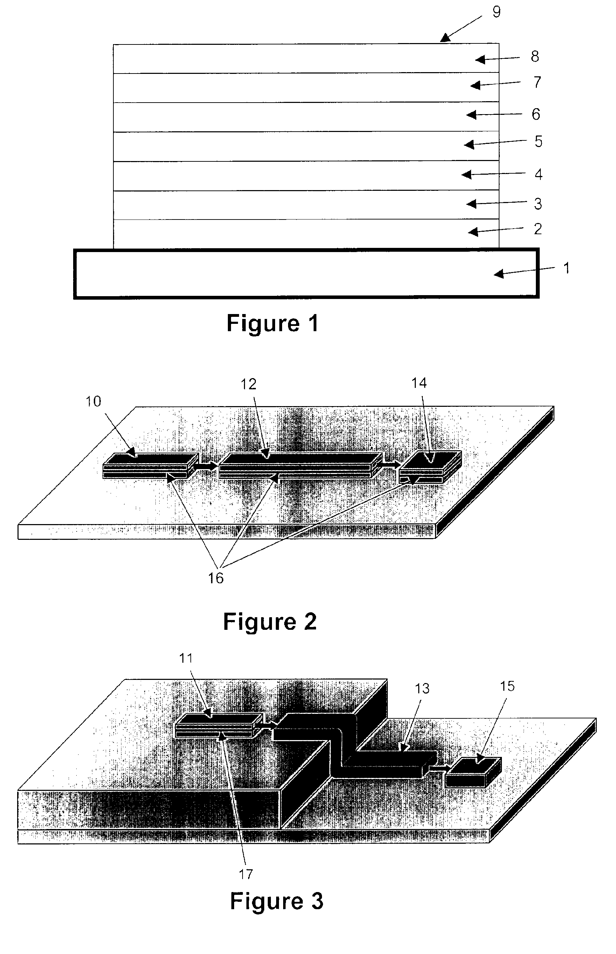

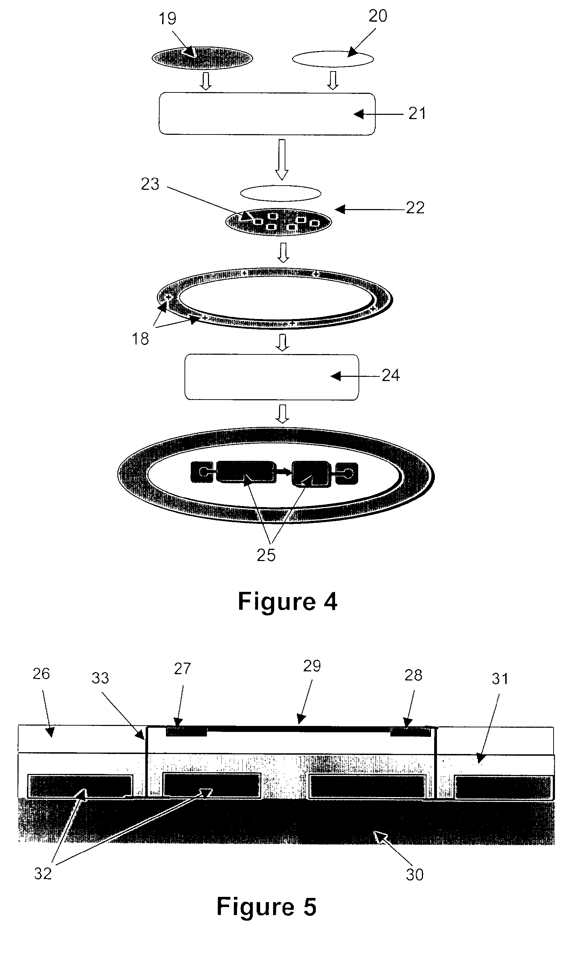

The fabrication procedure, for the wafer scale integration of Silicon ICs with the OE semiconductor devices, begins with the fabrication of the Silicon ICs.
The invention does not contain any restriction concerning the employed Silicon technology: It can be CMOS or BiCMOS with any minimum feature size; It can be standard foundry technology or more advanced (e.g. SOI). Different size of the Silicon and Gallium Arsenide wafers is not a limitation for the present fabrication procedure. Certainly, Silicon wafers have currently larger dimensions than those used for the epitaxy of III-V semiconductor materials for OE devices. Among these III-V wafers, Gallium Arsenide has, currently, the largest dimensions The fact that Silicon wafers can be larger than III-V wafers can be exploited by placing alignment marks on the uncovered surface of Silicon for the consequent process of the OE devices on the III-V semiconductors.
The procedure for the integration of Gallium Arsenide based optoelectronic devices is performed as follows:
The epitaxy of multiple thin layers of Gallium Arsenide is done in parallel and independently of the Silicon IC fabrication procedure. The multiple thin layers will be used for the consequent fabrication of OE devices (Laser diodes, Light Emitting Diodes, Optical modulators, photodetectors, etc.). The structure of the OE semiconductor devices is grown upside-down so as when the wafers of Silicon and Gallium Arsenide (GaAs) are bonded "face-to-face" the structure inspected from the backside of the Gallium Arsenide wafer is restored. The basic characteristics of the epitaxial structure, adequate for fabrication of edge-emitting lasers, are shown in Figure 1. The epitaxial structure is grown on a GaAs wafer (1) on which an additional GaAs layer (2) is grown for the improvement of the electrical and structural characteristics of the upcoming epitaxial layers. Consequently, the following layers are grown:
- an AlAs layer (3) which will be utilized as etch-stop layer,
- a GaAs layer (4) with p-type doping to serve as the anode of the OE diodes,
- a p-AlₓGa₁₋ₓAs layer (5) for the optical confinement of the produced light,
- the active layers of the OE diodes which consist of adequately designed AlₓGa₁₋ₓAs layers for the embodiment of the laser's waveguide and of multiple quantum wells of GaAs/ Al_{y}Ga_{1-y}As or Al_{y}Ga_{1-y}As/ In_{y}Ga_{1-y}As (6) for light emission,
- a n-AlₓGa₁₋ₓAs (7) layer for the optical confinement of the produced light and finally
- a layer of GaAs (8) with n-type doping for the formation of the anodes of the OE diodes.
The upper surface (9) of the top n-type GaAs layer will be bonded to the Silicon wafer. The AlAs (3) etch-stop layer can be either single or multiple (with intermediate GaAs layers) depending on the requirements of the etch-stop process. The AlAs is followed by the main semiconductor structure which starts with a p-type GaAs (4) layer.
The structures of the lasers and photodetectors can be either unique (Figure 2) or separate (Figure 3). The first choice has the advantage of simpler fabrication procedure but induces compromises on the performance of both OE devices. For both cases the system consists of a laser diode (10,11), a waveguide (12,13) (whenever required an optical link parallel to the Silicon surface) and a photodetector (14,15). The quantum wells (16, 17) are, also, shown on Figures 2 and 3. The second choice permits the performance optimization of both the laser diode and photodetector, but requires additional fabrication steps, such as the etching of the layers covering the photodetector structure. Just as soon as the fabrication of the Silicon ICs and of the epitaxial layers on Gallium Arsenide is finished, the two wafers are bonded "face-to-face". The bonding can be accomplished with one of the following methods: 1) With adhesive epoxies [Product E3082 or E3084 of EPOXY TECHNOLOGY, Inc.] and curing at relatively low temperature, 2) With the utilization of an intermediate layer of SiO₂, Si₃N₄ or SOG which must be deposited at low temperatures (using PECVD for SiO₂ and Si₃N₄). After the deposition of the intermediate layers, the wafer bonding is performed at low temperature [Low Temperature Wafer Direct Bonding, Qin-Yi Tong, Giho Cha,Roman Gafiteaunu, Ulrich Goesele, J. of Micromechanical Systems, Vol.3, No 1, March 1994, pp. 29-35].
The first method results to simpler process-flow, but currently the bonding uniformity is not fully assessed for large surfaces. The second method results to more complicated process-flow, but the bonding of large surfaces is actually better controlled. Both methods require SiO₂ intermediate layers deposited onto the wafers (the SiO₂ layer is imperative for the Silicon wafer and optional for the Gallium Arsenide wafer) at a temperature lower than 450°C followed by a Chemical-Mechanical Thinning and Polishing procedure to achieve flat and smooth bonding surfaces. For the bonding the temperature must be lower than 250°C [Low Temperature Wafer Direct Bonding, Qin-Yi Tong, Giho Cha,Roman Gafiteaunu, Ulrich Goesele, J. of Micromechanical Systems, Vol.3, No 1, March 1994, pp. 29-35], to prevent any Aluminum interconnect degradation of the Silicon ICs and to avoid debonding of the two wafers due to the different Thermal Expansion Coefficients. During the bonding procedure, the Gallium Arsenide wafer should be centered to the Silicon wafer. This wafer centering is not so critical and can be executed without employing any specific tool. More critical is the alignment of the two wafers because the Gallium Arsenide properties depend on the crystal orientation. Hence, during the bonding the major flats of the two wafers are mechanically aligned. After the accomplishment of the wafer bonding the back side of the Gallium Arsenide undergoes Chemical-Mechanical Thinning and
Polishing so as to reveal the epitaxial foil of the Gallium Arsenide (5-20 *µ*m of thickness) which contains the active layers of the OE devices. Afterwards starts the optical lithography process on the Gallium Arsenide surface for the definition of the laser diodes and photodetectors. The mask alignment of the OE devices to be fabricated on the Gallium Arsenide can be performed either with Infrared backside alignment or with the alignment marks (18) on the uncovered annulus of the Silicon wafer (Figure 4). The laser diodes can be either edge-emitting or Vertical Cavity Surface Emission Lasers (VCSEL). The mirrors of the edge-emitting lasers can be fabricated using either ECR (Electron Cyclotron Resonance) or ICP (Inductively Coupled Plasma) equipment; both of them use high density plasma and, therefore, elevated etch-rates can be achieved with low bias voltage on the substrate [GaAs/AlGaAs ridge lasers with etched mirrors formed by an inductively coupled plasma reactor, S.C. Horst, S.Agarwala, O.King, J.L.Fitz, S.D.Smith, Appl. Phys. Lett. 71, 11, 15 Sept. 1997, pp. 1444-1445]. However, it is possible to fabricate the mirrors using a Reactive Ion Etching (RIE) equipment. It is worthwhile noting that VCSEL diodes are more adequate than edge-emitting lasers for high density OE links for the following reasons: 1) they emit in a direction perpendicular to the surface and, thus, the optical losses due to substrate absorption are minimized 2) they consume less power. A drawback of the VCSELs, with the status of the related technology, is that their direct modulation speed lacks behind that of the edge-emitting lasers when relatively high optical power is needed. Consequently, whenever the system's requirement is to transmit data at a speed of tens of Gbit/s with relatively high optical power then the utilization of edge emitting lasers is mandatory under a direct modulation scheme.
Optical waveguiding, for paths parallel to the Silicon surface, can be fabricated with polymers, SiO₂, Si₃N₄, or using the unique epitaxial structure of the laser diode. Note that a combination of these materials can result in more efficient waveguides.
The fabrication of the laser diodes is followed by the processing of the Ohmic contacts for the lasers and the photodetectors as well as by the electrical interconnections of the OE devices with the Silicon ICs. At this stage of the process flow the temperature can rise up to 400°C because the constraint of the different Thermal Expansion Coefficients become more tolerant due to the preceding thinning of the Gallium Arsenide wafer (a GaAs foil of only 5-20*µ*m thickness remains intact) which now can sustain larger deformations. Metal interconnections can be accomplished with metallized via holes normal to the surface of the wafers. The entire process-flow diagram is shown in Figure 4. In summary, the entire procedure, as illustrated in Figure 4, includes the following steps: The CMOS or BiCMOS ICs are completely fabricated on the Silicon substrate (19) (having typically four inches diameter); in parallel the epitaxy of the OE structures is performed on the Gallium Arsenide substrate (20) (having typically three inches diameter). Afterwards, the two wafers are covered with low temperature deposited SiO₂ films; then the SiO₂. films undergo a Chemical-Mechanical Polishing procedure (21). Next, the two wafers are bonded "face-to-face" (22) using either an adhesive epoxy or a low temperature Wafer Bonding method. In Figure 4 the Silicon ICs (23) are illustrated as well. The next stage (24) is the Chemical-Mechanical Thinning and Polishing of the bonded Gallium Arsenide wafer so as to leave intact only a foil of 20-40 *µ*m. This foil of Gallium Arsenide undergoes a chemical etching process down to the AlAs (3) layer and, then, the fabrication of the OE devices (25) is performed.
The resulting OE system is illustrated in Figure 5. The basic components of the system, which are fabricated on the Gallium Arsenide (26), are the laser diodes (27), the photodetectors (28) and the optical waveguides (29). Between the OE components and
the Silicon wafer (30) is inserted an isolating layer (31) of SiO₂ or Si₃N₄ or adhesive epoxy (or a combination of them). The CMOS or BiCMOS ICs (32) are fabricated on the surface of the Silicon substrate. The electrical interconnections of the OE components with the Silicon ICs is achieved with metallized via holes (33).

## Claims

1. An integrated fabrication procedure of optoelectronic (OE) system comprising light-emitting (27) and photo-detecting (28) optoelectronic devices fabricated on III-V semiconductor epitaxial layers developed on a crystalline wafer (26) bonded on a Silicon wafer (30) on which CMOS/BiCMOS ICs are already fully processed (32),
**characterized in that** between the wafer with the III-V semiconductor epitaxial layers and the Silicon wafer are inserted isolating layers (31) of SOG or SiO₂ or Si₃N₄ (or a combination of them) which have been deposited at low temperature (below 450°C), and in that the bonding is achieved either with adhesive epoxy or with a low temperature (below 250°C) Wafer Bonding procedure. The present invention is characterized, also, by the three dimensional integration of microelectronic with optoelectronic components using a wafer scale fabrication procedure.

2. An integrated fabrication procedure of optoelectronic (OE) system, as claimed in Claim 1, in which the epitaxial semiconductor layers consist of Arsenide- and/or Arsenide/Nitride-based, III-V compound semiconductors developed on Gallium Arsenide wafer.

3. An integrated fabrication procedure of optoelectronic (OE) system, as claimed in Claim 1, comprising edge-emitting lasers fabricated with Arsenide-based compound semiconductor layers, in which mirror fabrication procedures are included in order to appropriately deflect the emitted light-beam, according to the requirements of each specific optoelectronic system. The mirrors are fabricated with an etching method, such as the Reactive Ion Etching (RIE).

4. An integrated fabrication procedure of optoelectronic (OE) system, as claimed in Claim 1, in which the edge-emitting laser structures have been replaced by Vertical Cavity Surface Emitting Laser (VCSEL) Arsenide-based III-V compound structures.

5. An integrated fabrication procedure of optoelectronic (OE) system, as claimed in Claim 1, in which the epitaxial semiconductor layers consist of Arsenide- and Nitride-based III-V compounds developed on Indium Phosphide (InP) wafer. In this case, the light can be transmitted through the Silicon wafer because the wavelength of the emitted light is close to 1.5 *µ*m.

6. An integrated fabrication procedure of optoelectronic (OE) system, as claimed in Claim 1, in which the epitaxial semiconductor layers consist of Nitride-based III-V compounds developed on a crystalline substrate such as Alumina (Al₂O₃), Gallium Arsenide, Silicon, etc.

7. An integrated fabrication procedure of optoelectronic (OE) system, as claimed in Claim 1, in which the Silicon substrate processed with a conventional technology (CMOS/BiCMOS) has been replaced by a Silicon-on-Insulator (SOI) based substrate. In this case, electronic circuitry with particular characteristics (such as radiation-hard electronic circuits) can be produced.
